# EUROPEAN PATENT APPLICATION

(11) **EP 4 432 351 A1**
(43) Date of publication of application: **18.09.2024**
(21) Application number: 22903139.8
(22) Date of filing: 14.11.2022
(51) Int. Cl.: H01L 23/552, H04B 1/38

(54) **CHIP SYSTEM AND COMMUNICATION DEVICE**

(30) Priority: 06.12.2021 CN 202111479134
(71) Applicant: Huawei Technologies Co., Ltd., Shenzhen, Guangdong 518129 (CN)
(72) Inventor: DU, Bai, Shenzhen, Guangdong 518129 (CN); JI, Zhongli, Shenzhen, Guangdong 518129 (CN); SHE, Fei, Shenzhen, Guangdong 518129 (CN); LI, Ruilin, Shenzhen, Guangdong 518129 (CN); GUO, Qingchao, Shenzhen, Guangdong 518129 (CN)
(74) Representative: Thun, Clemens
(86) International application number: PCT/CN2022/131597
(87) International publication number: WO 2023/103716

(57) **Abstract**

This application discloses a chip system and a communication device, and relates to the field of chip packaging technologies. The chip system includes a chip package body and an electromagnetic shielding enclosure. The chip package body is electrically connected to a circuit board by using a first connection part. The chip package body includes a package substrate and at least one chip that are electrically connected. The electromagnetic shielding enclosure includes a conductive first shielding structure and a conductive second shielding structure. The first shielding structure is connected to the package substrate. A first cavity included in the first shielding structure is configured to accommodate at least one chip. A first end of the second shielding structure is connected to the circuit board or a solder pad of the circuit board; or a second end of the second shielding structure is connected to the first shielding structure to form a second cavity; or a first end of the second shielding structure is connected to the circuit board or a solder pad of the circuit board, and the second shielding structure covers the first shielding structure to form a second cavity; and the first connection part is in the second cavity. In this solution, electromagnetic leakage of the first connection part is reduced, and an electromagnetic shielding capability of chip packaging is improved.

## Description

This application claims priority to Chinese Patent Application No. 202111479134.2, filed with the China National Intellectual Property Administration on December 6, 2021 and entitled "CHIP SYSTEM AND COMMUNICATION DEVICE", which is incorporated herein by reference in its entirety.

### TECHNICAL FIELD

This application relates to the field of chip technologies, and in particular, to a chip system and a communication device.

### BACKGROUND

As a semiconductor process size continuously decreases, integration of various chips in an electronic device gradually improves, and a working frequency of the chip continuously improves. Consequently, a conductive element or a conductive structure with a small size in the electronic device becomes an antenna, and electromagnetic radiation is performed outward, thereby causing electromagnetic interference to a radio frequency circuit that is included in the electronic device and that is easily affected by radio frequency interference, and a processor, a memory, and the like that need to use a clock signal. A conventional method for reducing impact of electromagnetic radiation is to set an electromagnetic shielding enclosure for a radiation device that generates electromagnetic radiation or a sensitive device that is easily affected by electromagnetic radiation.

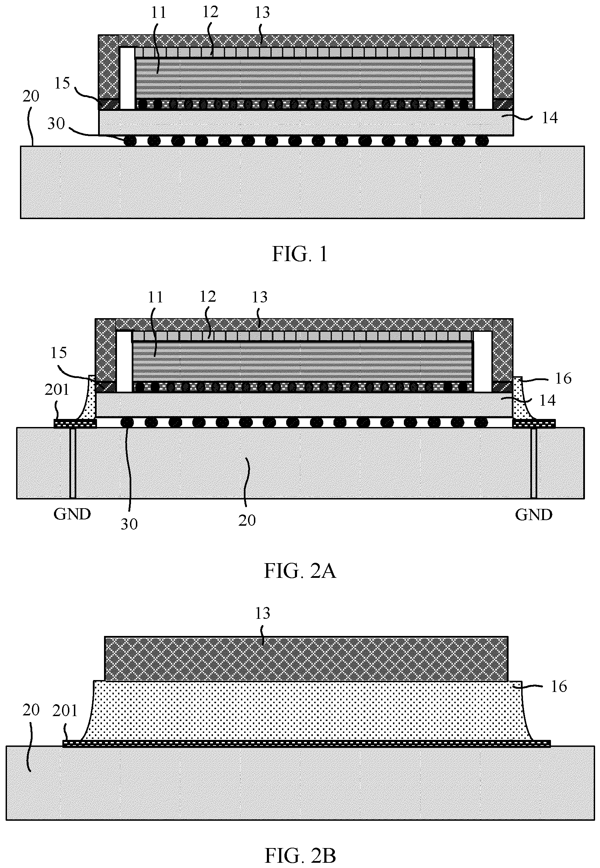

FIG. 1 is a diagram of an electromagnetic shielding enclosure of a conventional chip package body.

The chip package body shown in the figure includes a chip 11 and a package substrate 14. The chip 11 and the package substrate 14 are welded by using a solder ball. An electromagnetic shielding enclosure 13 is generally a technical stamping structure, covers an upper part of the chip 11, namely, a side surface, and is fastened to an upper surface of the package substrate 14 by using a connection part 15. An upper surface of the chip 11 is in contact with the electromagnetic shielding enclosure 13 by using a thermal interface material (Thermal interface material, TIM) 12, to accelerate heat dissipation. Electromagnetic radiation of the chip 11 may be reduced by using the electromagnetic shielding enclosure 13.

However, because the package substrate 14 is connected to a printed circuit board (Printed Circuit Board, PCB) 20 by using a solder ball 30, and there is a gap between solder balls 30, the solder balls 30 become a leakage source of the electromagnetic radiation. As a working frequency of the chip 11 continuously increases, a requirement for reducing electromagnetic radiation leakage continuously increases, and electromagnetic radiation leaked by the solder ball 30 may even seriously affect performance of the chip.

### SUMMARY

To resolve the foregoing problem, this application provides a chip system and a communication device, and this reduces electromagnetic leakage of a first connection part, improves an electromagnetic shielding capability of a chip, and ensure performance of the chip.

According to a first aspect, this application provides a chip system. The chip system includes a chip package body and an electromagnetic shielding enclosure. The chip package body is electrically connected to a circuit board by using a first connection part. In a typical implementation, the first connection part includes a solder ball. The chip package body includes a package substrate and at least one chip that are electrically connected, and the electromagnetic shielding enclosure includes a conductive first shielding structure and a conductive second shielding structure. The first shielding structure is connected to the package substrate, the first shielding structure includes a first cavity, and the first cavity is configured to accommodate at least one chip. A first end of the second shielding structure is connected to the circuit board or connected to a solder pad on the circuit board, and a second end of the second shielding structure is connected to the first shielding structure to form a second cavity; or a first end of the second shielding structure is connected to a solder pad on the circuit board or connected to the circuit board, and the second shielding structure covers the first shielding structure to form a second cavity; and the first connection part is located in the second cavity.

According to the chip system provided in this application, after the first shielding structure is connected to the second shielding structure, the formed second cavity encircles the first connection part. Because both the first shielding structure and the second shielding structure are conductive, the first shielding structure and the second shielding structure jointly perform a shielding function, to implement electromagnetic shielding on the first connection part, reduce electromagnetic leakage of the first connection part, improve an electromagnetic shielding capability, ensure chip performance, and reduce impact of electromagnetic leakage on another circuit component.

In a possible implementation, the first connection part includes an insulation material and a plurality of electrical connection parts, where the plurality of electrical connection parts are configured to connect the chip package body and the circuit board, and the insulation material is filled in a region between the package substrate of the chip package body, the circuit board, and the plurality of electrical connection parts.

In a typical implementation, the electrical connection part is a solder ball, the first connection part includes the solder ball and the insulation material, and the solder ball is configured to implement an electrical connection between the chip package body and the circuit board.

On one aspect, the insulation material may function as assisting in heat dissipation. On the other aspect, an insulation material filled between a connection region of the chip package body and the circuit board may further play a support role, so that the second shielding structure may be closely attached to a side wall of the insulation material, and is more stable and reliable. In addition, a connection areabetween the chip package body and the circuit board is increased, and stability of a connection between the chip package body and the circuit board is improved.

In a possible implementation, the first connection part filled with the insulation material includes two connection surfaces, one connection surface close to the circuit board is a first connection surface, one connection surface close to the chip package body is a second connection surface, and a width of the first connection surface is greater than a width of the second connection surface. That is, after the insulation material is filled, an upper side is narrow, and a lower side is wide, so that the insulation material can provide support for the second shielding structure.

In a possible implementation, the second shielding structure covers all or a part of side walls of the insulation material.

When the insulation material is filled in the connection region between the chip package body and the circuit board, the insulation material may be filled according to a capillary principle, and the second shielding structure covers all or a part of side walls of the insulation material, that is, metal solder balls are surrounded inside. This implements electromagnetic shielding on the metal solder balls. In addition, when the second shielding structure is in contact with an edge of the insulation material, the insulation material filled between the connection region of the chip package body and the circuit board can further play a support role, so that the second shielding structure can be closely attached to the side wall of the insulation material, and is more stable and reliable.

In a possible implementation, a first end of the second shielding structure is connected to a solder pad on the circuit board, to improve connection stability of the second shielding structure.

In a possible implementation, a first end of the second shielding structure is connected to a solder pad on the circuit board, and the solder pad is grounded. In this case, the electromagnetic shielding enclosure improves electromagnetic shielding capabilities on a chip and the first connection part.

In a possible implementation, the package substrate is located on the solder pad, and the first end of the second shielding structure is electrically connected to the solder pad.

In a possible implementation, the chip package body is electrically connected to the circuit board by using a land grid array LGA packaging technology, and a grounding pin of the chip package body is electrically connected to the second shielding structure. Because the solder pad is electrically connected to the first shielding structure by using the second shielding structure, when the solder pad is grounded, the second shielding structure and the first shielding structure are also grounded, and this improves electromagnetic shielding performance.

Further, when a part of grounding pins on the circuit board is located outside a range covered by an outline of the chip package body, the grounding pins may alternatively be electrically connected to the first shielding structure by using a soldering process, to avoid grounding through wiring and simplify a ground line.

In a possible implementation, a first surface of each of the at least one chip is connected to the first shielding structure by using a first material. A second surface of each of the at least one chip is electrically connected to a first surface of the package substrate, and the first shielding structure is connected to the first surface of the package substrate by using a second connection part.

The first material may be a thermal interface (Thermal Interface Material, TIM) material, and the thermal interface material is mostly a flexible material, for example, may be a gel or a silicone lipide material, and is filled between the first surface of the chip and the first shielding structure. On one aspect, this can assist in heat dissipation, so that heat generated when the chip works is quickly conducted to the first shielding structure. On the other aspect, this provides support for the first shielding structure, and stability of the first shielding structure is improved.

The first shielding structure is fastened to the first surface of the package substrate by using the second connection part, and the first shielding structure is further fastened to the first surface of the chip by using the first material, and this improves stability of the first shielding structure. After the package substrate is fastened to the circuit board by using the first connection part, a position of the first shielding structure relative to the circuit board is also fixed.

In a possible implementation, the second connection part is a metal solder, and the first shielding structure is welded to the first surface of the package substrate by using the second connection part. In this case, the first shielding structure is securely connected to the package substrate, and the electromagnetic shielding enclosure has good electromagnetic shielding performance. Alternatively, the second connection part is an electrically conductive adhesive, and the first shielding structure is connected to the first surface of the package substrate by using the second connection part. In this manner, the electromagnetic shielding enclosure can have good electromagnetic shielding performance. Alternatively, the second connection part is an insulation collosol, and the first shielding structure is connected to the first surface of the package substrate by using the second connection part. In this manner, manufacturing difficulty is reduced, and the first shielding structure can be securely connected to the package substrate.

In a possible implementation, a first surface of each of the at least one chip is connected to the first shielding structure by using a first material. A second surface of each of the at least one chip is electrically connected to a first surface of the package substrate. The first shielding structure is connected to a side wall of the package substrate by using a second connection part.

The first material may be a thermal interface material, and the first material is filled between the first surface of the chip and the first shielding structure. On one aspect, the first material can assist in heat dissipation, so that heat generated when the chip works is quickly conducted to the first shielding structure. On the other aspect, the first shielding structure is supported, and connection stability of the first shielding structure is improved. In addition, the first shielding structure is connected to the side wall of the package substrate, to encircle the chip package body, and this improves an electromagnetic shielding effect.

In a possible implementation, the second connection part is a metal solder, and the first shielding structure is welded to the side wall of the package substrate by using the second connection part. In this case, the first shielding structure is securely connected to the package substrate, and the electromagnetic shielding enclosure has good electromagnetic shielding performance. Alternatively, the second connection part is an electrically conductive adhesive, and the first shielding structure is connected to the side wall of the package substrate by using the second connection part. In this manner, the electromagnetic shielding enclosure can have good electromagnetic shielding performance. Alternatively, the second connection part is an insulation collosol, and the first shielding structure is connected to the side wall of the package substrate by using the second connection part. In this manner, manufacturing difficulty is reduced, and the first shielding structure can be securely connected to the package substrate.

In a possible implementation, the first shielding structure is a metal mechanical part.

The metal mechanical part may be a metal mechanical part that has a groove structure and that is in a punch form or through molding. This is not specifically limited in this embodiment of this application. The groove is configured to accommodate a corresponding part of the chip package body, to implement electromagnetic shielding on the chip package body.

In a possible implementation, the chip package body further includes an epoxy molding compound. Each of the at least one chip is buried in the epoxy molding compound. The first shielding structure covers an outer surface of the epoxy molding compound and the side wall of the package substrate.

On one aspect, the epoxy molding compound can assist in heat dissipation, so that heat generated when the chip works is quickly conducted to the first shielding structure. On the other aspect, the epoxy molding compound provides support for the first shielding structure, and this improves connection stability of the first shielding structure. In addition, the first shielding structure covers the outer surface of the epoxy molding compound and the side wall of the package substrate, to encircle the chip package body, and improve an electromagnetic shielding effect.

In a possible implementation, the chip package body further includes an epoxy molding compound, each of the at least one chip is buried in the epoxy molding compound, each of the at least one chip is electrically connected to a first surface of the package substrate, and the first shielding structure covers an outer surface of the epoxy molding compound and extends to the first surface of the package substrate.

On one aspect, the epoxy molding compound can assist in heat dissipation, so that heat generated when the chip works is quickly conducted to the first shielding structure. On the other aspect, the epoxy molding compound provides support for the first shielding structure, and this improves connection stability of the first shielding structure. In addition, the first shielding structure covers the outer surface of the epoxy molding compound and the side wall of the package substrate. This reduces a quantity of used epoxy molding compounds and reduces material consumption of the first shielding structure.

In a possible implementation, the first shielding structure is any one of a conductive film, a metal material, or an electrically conductive adhesive material.

When the first shielding structure is implemented by using a conductive film, the conductive film may be formed through spraying. When the first shielding structure is implemented by using a metal material, the metal material may be generated through metal sputtering deposition or deposition by using an electroplating process. When the first shielding structure is implemented by using an electrically conductive adhesive material, the electrically conductive adhesive material may be formed through coating.

In a possible implementation, the second shielding structure is any one of a conductive film, a metal material, or an electrically conductive adhesive material.

In a possible implementation, a plurality of electrical connection structures included in the first connection part may be any one of a metal solder ball, a sinter, a metal mechanical part, or a plug terminal. The electrical connection part may alternatively be implemented in another manner. Examples are not described one by one herein again in this application.

In a possible implementation, the second shielding structure completely covers the first shielding structure, to improve an electromagnetic shielding capability. When the second shielding structure is a conductive film, difficulty of forming the second shielding structure can be further reduced. In this case, the second shielding structure may be connected to the first shielding structure by using a cohesive material, that is, the cohesive material is added to a contact surface between the second shielding structure and the first shielding structure, to improve stability of a connection between the second shielding structure and the first shielding structure.

Implementations of the second shielding structure and the first shielding structure may be the same or may be different. This is not specifically limited in this application. When the second shielding structure is implemented by using a conductive film, the conductive film may be formed through spraying. When the second shielding structure is implemented by using a metal material, the metal material may be generated through metal sputtering deposition or deposition by using an electroplating process. When the second shielding structure is implemented by using an electrically conductive adhesive material, the electrically conductive adhesive material may be formed through coating.

In a possible implementation, the second shielding structure is located on an outer side of the first shielding structure, and at least a part of the second cavity is located between the package substrate and the circuit board.

In this case, the second shielding structure may be connected to the outer side of the first shielding structure, and is easy to be processed and formed. When the second shielding structure covers the first shielding structure, a position at which the first shielding structure is connected to the second shielding structure includes an inner shielding structure and an outer shielding structure, and this improves electromagnetic shielding performance. The second cavity is located between the package substrate and the circuit board, and is configured to accommodate the first connection part, to implement electromagnetic shielding on the first connection part.

According to a second aspect, this application further provides a communication device. The communication device includes the chip system provided in the foregoing implementations. A chip package body included in the communication device has a high requirement on electromagnetic shielding. Therefore, when the chip package body is mounted on a PCB, electromagnetic shielding needs to be performed on the chip package body more comprehensively and completely.

An electromagnetic shielding enclosure included in the communication device provided in this application can implement electromagnetic shielding on an electrical connection part in a first connection part, reduce electromagnetic leakage of the electrical connection part of the first connection part, improve an electromagnetic shielding capability of the chip package body, ensure chip performance, and reduce impact of electromagnetic leakage on another circuit component. Therefore, performance of the communication device is further improved.

In a possible implementation, the communication device is a radio frequency transceiver. The radio frequency transceiver is connected to a baseband processing unit (Base band Unit, BBU) of a base station through an optical fiber. The BBU is configured to process data transmitted by the radio frequency transceiver, and transmit to-be-transmitted data to the radio frequency transceiver. According to the technical solutions of this application, an electromagnetic shielding capability on the chip package body is improved, and working performance of the radio frequency transceiver is further improved.

In a possible implementation, at least one chip includes an intermediate frequency chip. The intermediate frequency chip is applied to an intermediate frequency circuit of the radio frequency transceiver.

### BRIEF DESCRIPTION OF DRAWINGS

FIG. 1 is a diagram of a conventional electromagnetic shielding enclosure;
FIG. 2A is a cross-sectional diagram of a chip system according to an embodiment of this application;
FIG. 2B is a side view corresponding to FIG. 2A according to an embodiment of this application;
FIG. 3 is a cross-sectional diagram of another chip system according to an embodiment of this application;
FIG. 4A is an enlarged diagram of a region A in FIG. 3 according to an embodiment of this application;
FIG. 4B is a top view corresponding to FIG. 3 according to an embodiment of this application;
FIG. 4C is a cross-sectional diagram of another chip system according to an embodiment of this application;
FIG. 5 is a waveform diagram of a simulation test according to an embodiment of this application;
FIG. 6 is a cross-sectional diagram of still another chip system according to an embodiment of this application;
FIG. 7 is a cross-sectional diagram of yet another chip system according to an embodiment of this application;
FIG. 8 is a cross-sectional diagram of another chip system according to an embodiment of this application;
FIG. 9 is a cross-sectional diagram of still another chip system according to an embodiment of this application;
FIG. 10 is a cross-sectional diagram of yet another chip system according to an embodiment of this application;
FIG. 11 is a cross-sectional diagram of another chip system according to an embodiment of this application;
FIG. 12 is a cross-sectional diagram of still another chip system according to an embodiment of this application;
FIG. 13A is a cross-sectional diagram 1 corresponding to FIG. 12 according to an embodiment of this application;
FIG. 13B is a cross-sectional diagram 2 corresponding to FIG. 12 according to an embodiment of this application;
FIG. 14 is a side view 1 corresponding to FIG. 12 according to an embodiment of this application;
FIG. 15A is a cross-sectional diagram 3 corresponding to FIG. 12 according to an embodiment of this application;
FIG. 15B is a cross-sectional diagram 4 corresponding to FIG. 12 according to an embodiment of this application;
FIG. 16A is a side view 1 corresponding to FIG. 15A and FIG. 15B according to an embodiment of this application;
FIG. 16B is a side view 2 corresponding to FIG. 15A and FIG. 15B according to an embodiment of this application; and
FIG. 17 is a diagram of a radio frequency transceiver system according to an embodiment of this application.

### DESCRIPTION OF EMBODIMENTS

To make a person skilled in the art better understand the technical solutions provided in the embodiments of this application, an application scenario of the technical solutions provided in this application is first described below.

As a working frequency of a chip continuously improves, a requirement for reducing electromagnetic interference is increased. Therefore, to improve performance of a chip package body, electromagnetic shielding needs to be performed on the chip package body more comprehensively, to reduce electromagnetic radiation leakage.

The chip package body includes a chip and a package substrate. The chip includes but is not limited to an intermediate frequency (Intermediate Frequency, IF) chip, a radio frequency (Radio Frequency, RF) chip, a central processing unit (Central Processing Unit, CPU), a graphics processing unit (Graphics Processing Unit, GPU), a field programmable gate array (Field Programmable Gate Array, FPGA), a neural network processing unit (Neural network Processing Unit, NPU), and the like.

For example, the chip package body is connected to a PCB by using a solder ball. Still refer to FIG. 1. A gap exists between each solder ball 30, so that the solder ball 30 becomes a leakage source of electromagnetic radiation, which affects performance of a chip 11, and further causes electromagnetic interference to a radio frequency circuit included in an electronic device, a processor, a memory, and the like that need to use a clock signal.

To resolve the foregoing technical problem, this application provides a chip system and a communication device. The chip system includes the chip package body and an electromagnetic shielding enclosure, where the chip package body is electrically connected to a circuit board by using a first connection part, and the chip package body includes a package substrate and at least one chip. The package substrate is electrically connected to the at least one chip. The electromagnetic shielding enclosure includes a conductive first shielding structure and a conductive second shielding structure. The first shielding structure is connected to the package substrate, a first cavity of the first shielding structure is configured to accommodate the at least one chip, a first end of the second shielding structure is connected to the circuit board or a solder pad on the circuit board, and a second end of the second shielding structure is connected to the first shielding structure to form a second cavity; or a first end of the second shielding structure is connected to a solder pad on the circuit board or the circuit board, and the second shielding structure covers the first shielding structure to form a second cavity. The first connection part is located in the second cavity. By using the electromagnetic shielding enclosure provided in this application, electromagnetic shielding can be implemented on the first connection part, and electromagnetic leakage of the first connection part is reduced, further to improve an electromagnetic shielding capability of the chip package body, ensure chip performance, and reduce impact of electromagnetic leakage on another circuit component.

To make a person skilled in the art understand the technical solutions in this application better, the following describes the technical solutions in embodiments of this application with reference to the accompanying drawings in embodiments of this application.

The terms "first" and "second" in this application are merely intended for a purpose of description, and shall not be understood as an indication or implication of relative importance or an implicit indication of a quantity of indicated technical features.

In addition, in this application, orientation terms such as "up" and "down" may include but are not limited to orientations schematically placed relative to components in the accompanying drawings. It should be understood that these directional terms may be relative concepts, and are used for relative description and clarification, and may be correspondingly changed based on changes in placement orientations of the components in the accompanying drawings.

In this application, unless otherwise expressly specified and limited, the term "connection" should be understood in a broad sense. For example, "connection" may be a fixed connection, a detachable connection, or an integrated connection, or may be a direct connection or an indirect connection through an intermediate medium.

The chip package body may include one chip or a plurality of chips. For ease of description, the following embodiments are described by using an example in which the chip package body includes one chip.

FIG. 2A is a cross-sectional diagram of a chip system according to an embodiment of this application.

A chip package body shown in the figure includes a chip 11 and a package substrate 14.

The package substrate 14 may be a circuit board including a plurality of conductive layers, and an exposed solder pad structure is disposed on both an upper surface and a lower surface of the package substrate 14.

The chip 11 is electrically connected to the package substrate 14. In a possible implementation, a surface of the chip 11 includes a metal bump, the chip 11 and the package substrate 14 are welded, and a solder may be a tin-containing alloy solder Solder paste is printed on a surface of the substrate, and a connection between the chip and the substrate is implemented in a reflow soldering manner.

When the chip package body is welded to a PCB 20, the electromagnetic shielding enclosure provided in this application is used to implement electromagnetic shielding on the chip package body. The electromagnetic shielding enclosure includes a first shielding structure 13 and a second shielding structure 16.

Both the first shielding structure 13 and the second shielding structure 16 are conductive structures.

The first shielding structure 13 is connected to the package substrate 14, the first shielding structure 13 includes a first inner cavity, and the chip 11 is located in the first inner cavity of the first shielding structure 13.

The second shielding structure 16 is located on an outer side of the first shielding structure 13, and at least a part of a second cavity is located between the package substrate and the circuit board. In this case, the second shielding structure may be connected to the outer side of the first shielding structure, and is easy to be processed and formed. When the second shielding structure covers the first shielding structure, a position at which the first shielding structure is connected to the second shielding structure includes an inner shielding structure and an outer shielding structure, and this improves electromagnetic shielding performance. The second cavity is located between the package substrate and the circuit board, and is configured to accommodate the first connection part, to implement electromagnetic shielding on the first connection part.

The chip package body is electrically connected to the PCB 20 by using the first connection part.

The first connection part includes a plurality of electrical connection parts. The electrical connection part may include a metal solder ball, a sinter, a metal mechanical part, a plug terminal, or the like, or may be another electrical connection part, to implement an electrical connection between the first connection part and the PCB 20. This is not specifically limited in this embodiment of this application. The following description is provided by using an example in which the electrical connection part of the first connection part is a metal solder ball 30.

FIG. 2B is a side view corresponding to FIG. 2A according to an embodiment of this application.

FIG. 2B is a diagram of external observation. Refer to FIG. 2A and FIG. 2B together A first end of the second shielding structure 16 is connected to the circuit board 20, or is connected to a solder pad 201 on the circuit board 20, a second end of the second shielding structure 16 is connected to the first shielding structure 13 to form a second cavity, and the second shielding structure 16 completely covers a side surface of the package substrate, and makes the first connection part be in the second cavity formed by surrounding the second shielding structure 16. In this case, in the diagram of external observation shown in FIG. 2B, the first connection part is completely shielded by the second shielding structure 16.

In this case, an electromagnetic shielding enclosure formed by the first shielding structure 13 and the second shielding structure 16 together covers the chip package body and the first connection part. This reduces electromagnetic leakage of the first connection part, improves an electromagnetic shielding capability of the chip package body, ensures chip performance, and reduces impact of electromagnetic leakage on another circuit component.

In some other possible implementations, the second shielding structure 16 partially covers the side surface of the package substrate, so that a material can be saved.

The following provides a description with reference to specific implementations.

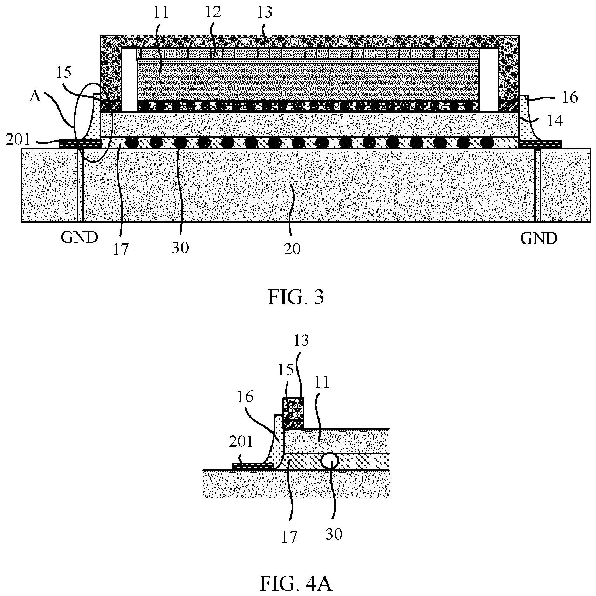

FIG. 3 is a cross-sectional diagram of another chip system according to an embodiment of this application.

A package substrate 14 and a PCB 20 in this embodiment of this application may be connected in a ball grid array (Ball Grid Array, BGA) packaging manner or a land grid array (Land Grid Array, LGA) packaging manner.

When the BGA packaging manner is used, a plurality of solder balls between the package substrate 14 and the PCB 20 form an array, and are distributed between the package substrate and the PCB 20, so that the PCB 20 communicates with a chip package body.

When the LGA packaging manner is used, a contact required when the chip package body is connected to the PCB 20 is located on the PCB 20, and a lower side of the package substrate covers a grid-shape connection end. The PCB 20 communicates with the chip package body by using a point contact technology. The PCB 20 provides a pin, which may replace the solder ball in the BGA packaging.

For ease of description, the following uses the BGA packaging as an example. In this case, a plurality of electrical connection parts of the first connection part in FIG. 3 is specifically a plurality of metal solder balls 30. A quantity and an arrangement manner of the metal solder balls are not specifically limited in this embodiment of this application. It may be understood that, in some other embodiments, when the LGA packaging manner is used, the first connection part includes a pin and a contact. Details are not described in this embodiment of this application.

A first surface of the chip 11 is fastened to a first shielding structure 13 by using a first material 12.

In a possible implementation, the first material 12 is a thermal interface (Thermal Interface Material, TIM) material. The thermal interface material is mostly a flexible material, for example, may be a gel or a silicone lipide material. When the thermal interface material is filled between the first surface of the chip 11 and the first shielding structure 13, on one aspect, heat dissipation can be assisted, so that heat generated when the chip 11 works is quickly conducted to the first shielding structure, and on the other aspect, support for the first shielding structure 13 is provided, to improve stability of the first shielding structure 13.

A second surface of the chip 11 is electrically connected to a first surface of the package substrate 14.

Specifically, a surface of the chip 11 includes a metal bump, an upper surface of the package substrate 14 includes a solder pad, solder paste is printed on the surface of the package substrate 14, and soldering of the chip 11 and the package substrate 14 is implemented in a reflow soldering manner.

In some embodiments, an underfill (underfill) material may be injected between the chip 11 and the package substrate 14, to improve connection stability. The underfill material is an insulation material. A specific type of the underfill material is not limited in this embodiment of this application, for example, may be epoxy resin.

The first shielding structure 13 is fastened to the first surface of the package substrate 14 by using a second connection part 15.

Because the first shielding structure 13 is fastened to the first surface of the package substrate 14 by using the second connection part 15, and the first shielding structure 13 is further fastened to the first surface of the chip 11 by using the first material 12, stability of the first shielding structure 13 is improved. After the package substrate is fastened to the circuit board 20 by using the first connection part, a position of the first shielding structure 13 relative to the circuit board is fixed.

In this case, the first shielding structure 13 is a metal mechanical part, and the metal mechanical part may be in a punch form or through casting. This is not specifically limited in this embodiment of this application. The metal mechanical part has a groove structure, and the groove is configured to accommodate a corresponding part of the chip package body, to implement electromagnetic shielding on the chip package body.

In a possible implementation, the second connection part 15 is a metal solder, and the first shielding structure 13 is welded to the first surface of the package substrate 14 by using the second connection part 15. In this case, the first shielding structure 13 is securely connected to the package substrate 14, and an electromagnetic shielding enclosure has good electromagnetic shielding performance.

In another possible implementation, the second connection part 15 is an electrically conductive adhesive, and the first shielding structure 13 is fastened to the first surface of the package substrate 14 by using the second connection part 15. In this manner, the electromagnetic shielding enclosure can have good electromagnetic shielding performance.

In still another possible implementation, the second connection part is an insulation collosol, and the first shielding structure 13 is fastened to the first surface of the package substrate 14 by using the second connection part 15. In this manner, manufacturing difficulty is reduced, and the first shielding structure 13 can be securely connected to the package substrate.

A lower surface of the package substrate 14 is electrically connected to the PCB 20 by using a metal solder ball 30. Specifically, an electrical connection between a substrate circuit 14 and the PCB may be implemented by using a reflow soldering process.

The PCB 20 includes a plurality of circuit layers. The PCB shown in the figure is merely an example, and does not constitute a limitation on the technical solutions of this application.

There is a solder pad 201 on the PCB. The solder pad 201 is a metal solder pad. The solder pad 201 is connected to a ground circuit layer of the PCB. The solder pad 201 may be connected to the ground circuit layer in a manner of a plated through-hole structure or a slotted electroplated structure. This is not specifically limited in this embodiment of this application.

In addition to the electrical connection part, namely, the metal solder ball 30 in the figure, the first connection part further includes an insulation material 17.

A connection region between the chip package body and the circuit board 20 is filled with the insulation material 17, that is, a connection region between the lower surface of the package substrate 14 and the PCB 20 is filled with the insulation material 17.

The insulation material 17 may be the underfill (underfill) material, for example, an epoxy resin material. The insulation material 17 may fill gaps between a plurality of metal solder balls according to a capillary principle.

The insulation material 17 may be filled with the gaps between the plurality of metal solder balls as much as possible, or the insulation material 17 is filled only at an edge of the connection region between the chip package body and the circuit board 20.

The second shielding structure 16 shown in the figure covers a side wall of the insulation material 17. A first end of the second shielding structure 16 is connected to the solder pad 201, and the solder pad 201 is grounded, further to improve an electromagnetic shielding capability of the electromagnetic shielding enclosure for the chip 11 and the first connection part. A second end of the second shielding structure 16 is connected to the first shielding structure 13.

In this case, the second shielding structure 16 encloses the metal solder balls 30 on an inner side, to implement electromagnetic shielding on the metal solder balls 30.

The insulation material 17 can further play a support role, so that the second shielding structure may be closely attached to a side wall of the insulation material, and is more stable and reliable.

The second shielding structure 16 is any one of a conductive film, a metal material, or an electrically conductive adhesive material. This is not specifically limited in this embodiment of this application.

When the second shielding structure 16 is a conductive film, the conductive film may be formed through spraying.

When the second shielding structure 16 is made of a metal material, the metal material may be generated through metal sputter deposition, or may be formed through deposition by using an electroplating process. The metal material may be copper, silver, or another metal material. This is not specifically limited in this embodiment of this application.

When the second shielding structure 16 is an electrically conductive adhesive material, the electrically conductive adhesive material may be formed through coating. A commonly used conductive adhesive material may be an electrically conductive adhesive material including metal silver, namely, conductive silver adhesive.

FIG. 4A is an enlarged diagram of a region A in FIG. 3 according to an embodiment of this application.

When the insulation material 17 is filled, the side wall formed by the insulation material 17 extends outwards in a top-down direction.

In this case, a first connection part filled with the insulation material 17 includes two connection surfaces, one connection surface close to the circuit board is a first connection surface, and the other connection surface close to the chip package body is a second connection surface.

A width of the first connection surface is greater than a width of the second connection surface. That is, an upper side of the insulation material 17 is narrow, and a lower side is wide.

When a material of the second shielding structure 16 is an implementation of the conductive film, the conductive film may be formed through spraying and relying on a side wall of the insulation material 17, to ensure that the second shielding structure 16 encloses the metal solder balls 30 on the inner side.

When the second shielding structure is implemented by using a metal material, the metal material may be formed through metal sputter deposition or deposition by using an electroplating process, or may be formed by relying on a side wall of the insulation material 17, to ensure that the second shielding structure 16 encircles the metal solder balls 30 on the inner side.

When the second shielding structure is implemented by using an electrically conductive adhesive material, the electrically conductive adhesive material may be formed through coating and relying on a side wall of the insulation material 17, to ensure that the second shielding structure 16 encircles the metal solder balls 30 on the inner side.

In conclusion, the side wall of the insulation material 17 may provide support for the second shielding structure 16. In addition, the insulation material 17 may alternatively reinforce a connection between the PCB and the package substrate.

The insulation material 17 in the following accompanying drawings and descriptions of this application is a filling manner in FIG. 4A. Details are not described one by one.

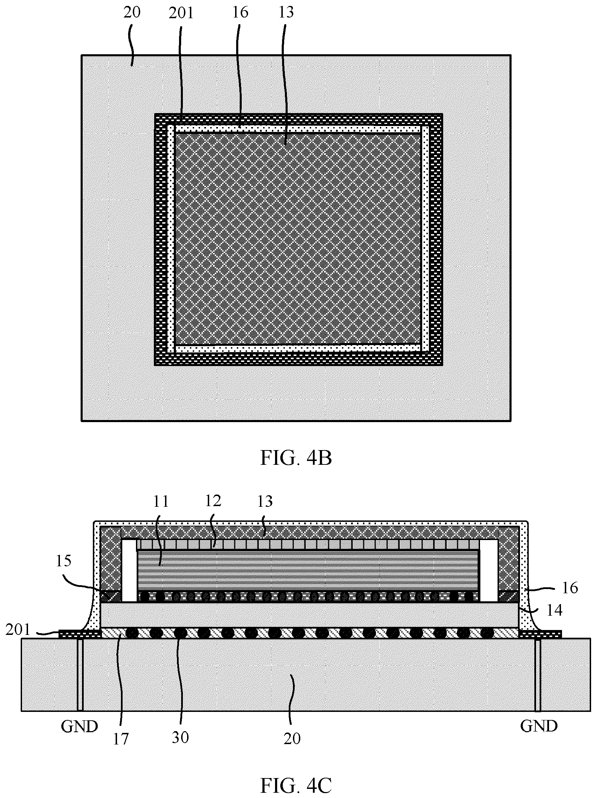

FIG. 4B is a top view corresponding to FIG. 3 according to an embodiment of this application.

A top view shown in FIG. 4B is a cross-sectional view of a top view angle. The first shielding structure 13, the second shielding structure 16, and the PCB 20 jointly form a cavity. The second shielding structure 16 completely covers a side surface of the package substrate 14, and makes the first connection part be in the cavity formed by surrounding the second shielding structure 16.

A solder pad shown in FIG. 4B surrounds the chip package body, and is configured to be fully fastened to the first end of the second shielding structure 16, to improve connection stability of the second shielding structure 16 and improve an electromagnetic shielding capability of an electromagnetic shielding enclosure.

In some other embodiments, the solder pad may not be surrounded by the chip package body, to save materials.

In this case, an electromagnetic shielding enclosure formed by the first shielding structure 13 and the second shielding structure 16 together covers the chip package body and the first connection part. This reduces electromagnetic leakage of the first connection part, improves an electromagnetic shielding capability of the chip package body, ensures chip performance, and reduces impact of electromagnetic leakage on another circuit component.

FIG. 4C is a cross-sectional diagram of an electromagnetic shielding enclosure of another chip package body according to an embodiment of this application.

In this implementation, a second shielding structure 16 of the electromagnetic shielding enclosure is a conductive film, and the conductive film may further completely cover the second shielding structure 13. In this case, the second shielding structure 16 may be connected to the first shielding structure 13 by using a cohesive (Cohensive) material, that is, the cohesive material is added to a contact surface between the second shielding structure 16 and the first shielding structure 13, to improve stability of a connection between the second shielding structure 16 and the first shielding structure 13.

The following describes a technical effect of the electromagnetic shielding enclosure shown in FIG. 3 with reference to specific test data.

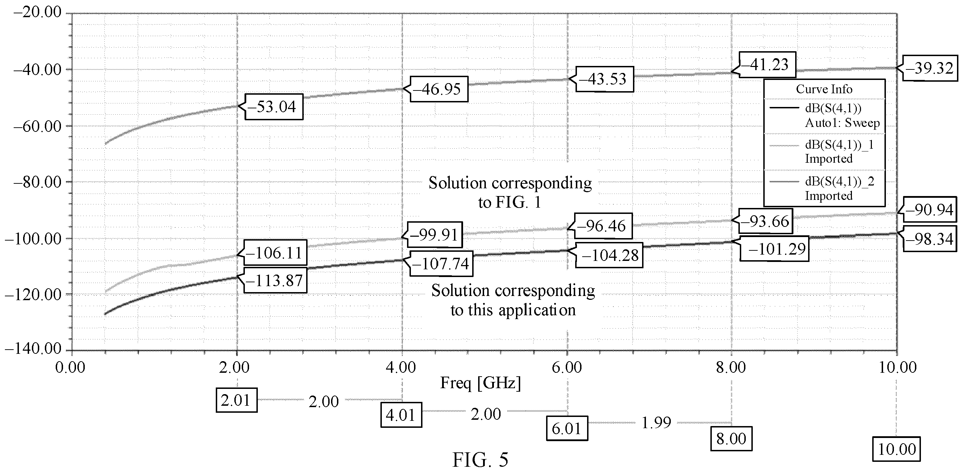

FIG. 5 is a waveform diagram of a simulation test according to an embodiment of this application.

The waveforms of the simulation test illustrated illustrate shielding effectiveness in a frequency band from 2 GHz to 10 GHz when the solutions of FIG. 3 and FIG. 1 are used, respectively.

The shielding effectiveness indicates attenuation of an electromagnetic wave by a shielding body. Because the shielding body can usually attenuate an electromagnetic wave strength to one hundredth to one to ten thousandth of an original strength, it is usually expressed in decibels (dB).

Data of the simulation test in FIG. 5 corresponds to the following Table 1.

**Table 1: Comparison of shielding effectiveness**

| Frequency | Shielding effectiveness of the solution in FIG. 1 | Shielding effectiveness of the solution in FIG. 3 |
|---|---|---|
| 2 GHz | 53.07 dB | 60.83 dB |
| 4 GHz | 52.96 dB | 60.79 dB |
| 6 GHz | 52.93 dB | 60.75 dB |
| 8 GHz | 52.43 dB | 60.06 dB |
| 10 GHz | 51.62 dB | 59.02 dB |

It may be learned that, compared with the conventional technology shown in FIG. 1, shielding effectiveness may be increased by about 7 dB to 8 dB by using the electromagnetic shielding enclosure in this embodiment of this application. That is, electromagnetic leakage of a solder ball can be reduced, thereby improving an electromagnetic shielding capability of the chip package body, and ensuring chip performance.

The following describes other implementations of the electromagnetic shielding enclosure.

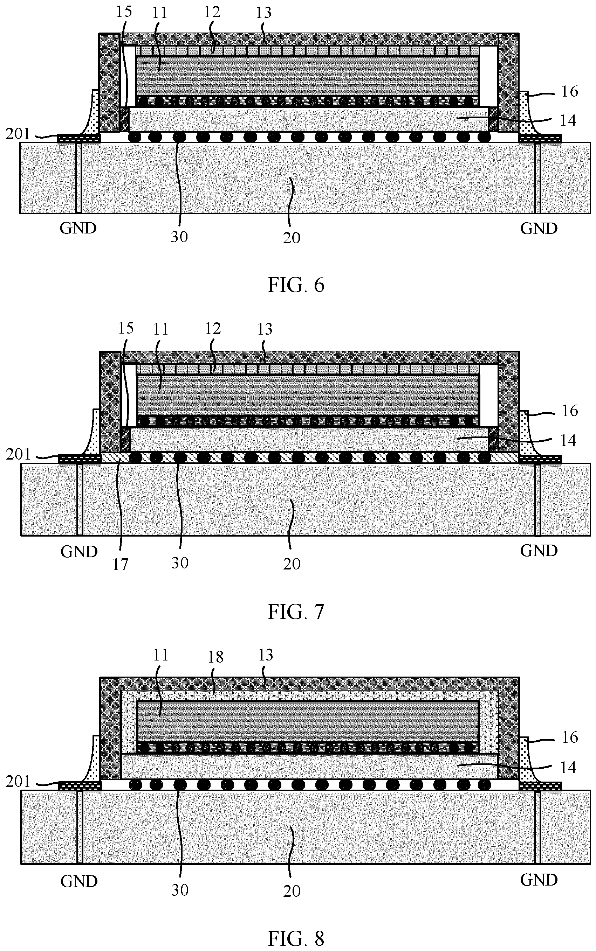

FIG. 6 is a cross-sectional diagram of still another chip system according to an embodiment of this application.

A first surface of a chip 11 is connected to a first shielding structure 13 by using a first material 12. A second surface of the chip 11 is electrically connected to a first surface of a package substrate 14. The first shielding structure 13 is fastened to a side wall of the package substrate 14 by using a second connection part 15.

In a possible implementation, the first material 12 may be a thermal interface material, and the thermal interface material is filled between the first surface of the chip 11 and the first shielding structure. On one aspect, the thermal interface material can assist in heat dissipation, so that heat generated when the chip works is quickly conducted to the first shielding structure. On the other aspect, support for the first shielding structure is provided, and stability of the first shielding structure is improved. In addition, the first shielding structure is fastened to the side wall of the package substrate, so that a side surface of the chip package body is encircled, and this improves an electromagnetic shielding effect.

In a possible implementation, the second connection part 15 is a metal solder, and the first shielding structure 13 is welded to the side wall of the package substrate 14 by using the second connection part 15. In this case, the first shielding structure 13 is securely connected to the package substrate 14, and the electromagnetic shielding enclosure has good electromagnetic shielding performance.

In another possible implementation, the second connection part 15 is an electrically conductive adhesive, and the first shielding structure 13 is fastened to the side wall of the package substrate 14 by using the second connection part 15. In this manner, the electromagnetic shielding enclosure can have good electromagnetic shielding performance.

In still another possible implementation, the second connection part 15 is an insulation collosol, and the first shielding structure 13 is fastened to the side wall of the package substrate 14 by using the second connection part 15. In this manner, manufacturing difficulty is reduced, and the first shielding structure can be securely connected to the package substrate.

A first end of the second shielding structure 16 is connected to a solder pad 201. The solder pad 201 is grounded, so that electromagnetic shielding capabilities of the electromagnetic shielding on a chip and a first connection part are improved. A second end of the second shielding structure 16 is connected to the first shielding structure 13.

FIG. 7 is a cross-sectional diagram of yet another chip system according to an embodiment of this application.

A difference between the implementation shown in the figure and the implementation shown in FIG. 6 lies in that the first connection part further includes an insulation material 17.

The insulation material 17 is filled between a chip package body, a circuit board 20, and a plurality of metal solder balls 30, that is, the insulation material 17 is filled in a gap between a lower surface of a package substrate 14 and the PCB 20.

The insulation material 17 may be the underfill (underfill) material, for example, an epoxy resin material. The insulation material 17 may fill gaps between a plurality of metal solder balls according to a capillary principle.

The insulation material 17 may fill the gap between the chip package body, the circuit board 20, and the plurality of metal solder balls as much as possible, or fill the insulation material 17 only at an edge of a connection region between the chip package body and the circuit board 20.

The second shielding structure 16 covers a side wall of the insulation material 17. A first end of the second shielding structure 16 is connected to a solder pad 201, and the solder pad 201 is grounded, thereby improving an electromagnetic shielding capability of the electromagnetic shielding enclosure for a chip and the first connection part. A second end of the second shielding structure 16 is connected to a first shielding structure 13.

In conclusion, the electromagnetic shielding enclosure provided in this application is used, so that electromagnetic shielding on the first connection part can be implemented, and electromagnetic leakage of the first connection part is reduced, to further improve an electromagnetic shielding capability of the chip package body, ensure chip performance, and reduce impact of electromagnetic leakage on another circuit component.

The following describes implementations of another electromagnetic shielding enclosure.

FIG. 8 is a cross-sectional diagram of another chip system according to an embodiment of this application.

A chip package body shown in FIG. 8 further includes an epoxy molding compound 18, and a chip 11 is buried in the epoxy molding compound 18.

The chip 11 is electrically connected to a first surface of a package substrate 14, and a first shielding structure covers an outer surface of the epoxy molding compound 18 and a side wall of the package substrate 14.

In this case, a first shielding structure 13 may be a conductive film, a metal material, or an electrically conductive adhesive material.

Specifically, when the first shielding structure 13 is implemented by using the conductive film, the conductive film may be formed through spraying.

When the first shielding structure 13 is implemented by using the metal material, the metal material may be formed through metal sputter deposition or deposition by using an electroplating process, and the metal material may alternatively be a metal mechanical part that is formed through stamping or casting.

When the first shielding structure 13 is implemented by using the electrically conductive adhesive material, the electrically conductive adhesive material may be formed through coating.

In one aspect, the epoxy molding compound 18 can assist in heat dissipation, so that heat generated when the chip works is quickly conducted to the first shielding structure 13. In another aspect, the epoxy molding compound 18 provides support for the first shielding structure 13, and this improves stability of the first shielding structure, and enables the first shielding structure 13 to be formed against the epoxy molding compound 18.

The first shielding structure 13 covers an outer surface of the epoxy molding compound 18 and a side wall of the package substrate 14, to encircle the chip package body, and this improves an electromagnetic shielding effect.

A second surface of the chip 11 is electrically connected to a first surface of the package substrate 14.

In a possible implementation, a surface of the chip 11 includes a metal bump, an upper surface of the package substrate 14 includes a solder pad, solder paste is printed on the surface of the package substrate 14, and the chip 11 and the package substrate 14 are welded in a reflow soldering manner. In some embodiments, an underfill material may be injected between the chip 11 and the package substrate 14, to improve connection stability. The underfill material is an insulation material. A specific type of the underfill material is not limited in this embodiment of this application, for example, may be epoxy resin.

A lower surface of the package substrate 14 is electrically connected to the PCB 20 by using a metal solder ball 30. Specifically, a substrate circuit 14 may be electrically connected to the PCB by using a reflow soldering process.

There is a solder pad 201 on the PCB. The solder pad 201 is a metal solder pad. The solder pad 201 is connected to a ground circuit layer of the PCB. The solder pad 201 may be connected to the ground circuit layer of the PCB through a plated through-hole structure or a slotted electroplated structure. This is not specifically limited in this embodiment of this application.

A second shielding structure 16 encircles metal solder balls 30 on an inner side, and this implements electromagnetic shielding on the metal solder balls 30. Implementations of the second shielding structure and the first shielding structure may be the same or may be different. This is not specifically limited in this application.

When the second shielding structure is implemented by using a conductive film, the conductive film may be formed through spraying. When the second shielding structure is implemented by using a metal material, the metal material may be generated through metal sputtering deposition or deposition by using an electroplating process. When the second shielding structure is implemented by using an electrically conductive adhesive material, the electrically conductive adhesive material may be formed through coating.

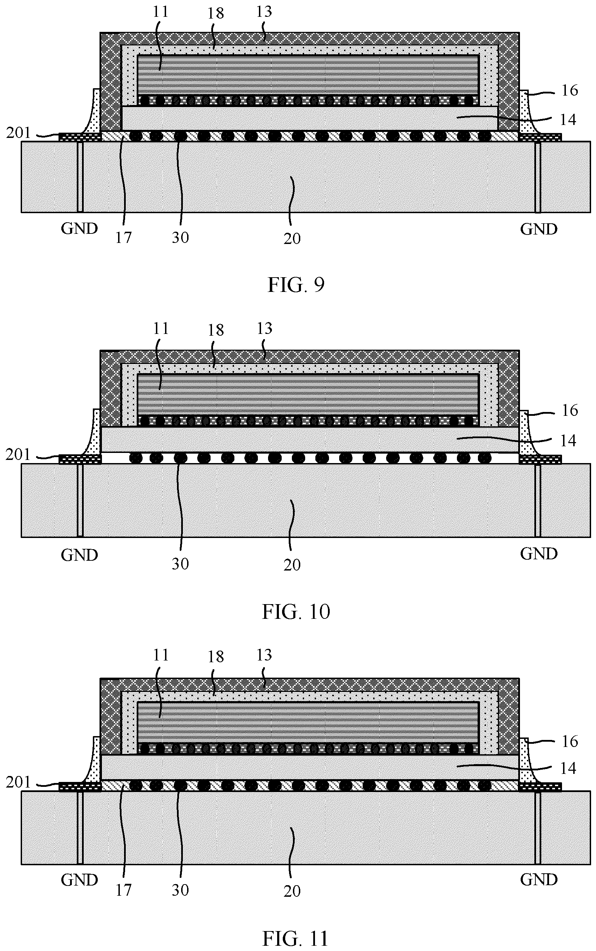

FIG. 9 is a cross-sectional diagram of still another chip system according to an embodiment of this application.

A difference between the implementation shown in the figure and the implementation shown in FIG. 8 lies in that the first connection part further includes an insulation material 17.

A region between a package substrate of a chip package body, a circuit board 20, and a plurality of metal solder balls is filled with the insulation material 17, that is, a gap between a lower surface of the package substrate 14 and the PCB 20 is filled with the insulation material 17.

The insulation material 17 may be an underfill material, for example, an epoxy resin material. The insulation material 17 may fill gaps between the plurality of metal solder balls according to a capillary principle.

The insulation material 17 may fill as much as possible the region between the package substrate of the chip package body, the circuit board 20, and the plurality of metal solder balls, or fill only an edge of a connection region between the chip package body and the circuit board 20.

A second shielding structure 16 covers a side wall of the insulation material 17. A first end of the second shielding structure 16 is connected to a solder pad 201. Grounding of the solder pad 201 improves an electromagnetic shielding capability of an electromagnetic shielding enclosure for a chip and the first connection part. A second end of the second shielding structure 16 is connected to a first shielding structure 13.

In conclusion, the electromagnetic shielding enclosure provided in this application is used, so that electromagnetic shielding on the first connection part can be implemented, and electromagnetic leakage of the first connection part is reduced, to further improve an electromagnetic shielding capability of the chip package body, ensure chip performance, and reduce impact of electromagnetic leakage on another circuit component.

The following describes a diagram of an electromagnetic shielding enclosure of still another chip package body.

FIG. 10 is a cross-sectional diagram of yet another chip system according to an embodiment of this application.

A difference between an electromagnetic shielding enclosure shown in FIG. 10 and that in FIG. 8 lies in that: a first shielding structure 13 covers an outer surface of an epoxy molding compound 18 and extends to a first surface of a package substrate 14.

On one aspect, the epoxy molding compound 18 can assist in heat dissipation, so that heat generated when a chip 11 works is quickly conducted to the first shielding structure 13. On the other aspect, the epoxy molding compound 18 provides support for the first shielding structure 13, and this improves stability of fastening the first shielding structure. In addition, the first shielding structure covers an outer surface of the epoxy molding compound and a side wall of the package substrate. Compared with the implementation in FIG. 8, a quantity of used epoxy molding compounds 18 is reduced and material consumption of the first shielding structure 13 is reduced.

When the first shielding structure 13 is implemented by using a conductive film, the conductive film may be formed through spraying. When the first shielding structure 13 is implemented by using a metal material, the metal material may be generated through metal sputtering deposition or deposition by using an electroplating process. When the first shielding structure 13 is implemented by using an electrically conductive adhesive material, the electrically conductive adhesive material may be formed through coating.

A first end of a second shielding structure 16 is connected to a solder pad 201 on a PCB 20, and the solder pad 201 is grounded to improve an electromagnetic shielding capability of an electromagnetic shielding enclosure for a chip and a metal solder ball. A second end of the second shielding structure 16 is connected to the first shielding structure 13. In this case, the second shielding structure 16 further covers a side surface of the package substrate 14.

Implementations of the second shielding structure 16 and the first shielding structure 13 may be the same or may be different. This is not specifically limited in this embodiment of this application. When the second shielding structure 16 is implemented by using a conductive film, the conductive film may be formed through spraying. When the second shielding structure 16 is implemented by using a metal material, the metal material may be generated through metal sputtering deposition or deposition by using an electroplating process. When the second shielding structure 16 is implemented by using an electrically conductive adhesive material, the electrically conductive adhesive material may be formed through coating.

FIG. 11 is a cross-sectional diagram of another chip system according to an embodiment of this application.

A difference between the implementation shown in the figure and the implementation shown in FIG. 10 lies in that the first connection part further includes an insulation material 17.

A region between a package substrate of a chip package body, a circuit board 20, and a plurality of metal solder balls 30 is filled with the insulation material 17, that is, a gap region between a lower surface of a package substrate 14 and the PCB 20 is filled with the insulation material 17.

The insulation material 17 may be an underfill material, for example, an epoxy resin material. The insulation material 17 may fill gaps between the plurality of metal solder balls according to a capillary principle.

The insulation material 17 may fill as much as possible the region between the package substrate of the chip package body, the circuit board 20, and the plurality of metal solder balls 30, or fill only an edge of a connection region between the chip package body and the circuit board 20.

The second shielding structure 16 covers a side wall of the insulation material 17. A first end of the second shielding structure 16 is connected to a solder pad 201, and the solder pad 201 is grounded, thereby improving an electromagnetic shielding capability of the electromagnetic shielding enclosure for a chip and the first connection part. A second end of the second shielding structure 16 is connected to a first shielding structure 13.

In conclusion, by using the electromagnetic shielding enclosure provided in this application, electromagnetic shielding can be implemented on the first connection part, and electromagnetic leakage of the first connection part is reduced, thereby improving an electromagnetic shielding capability of the chip package body, ensuring chip performance, and reducing impact of electromagnetic leakage on another circuit component.

The following describes an implementation of another chip system.

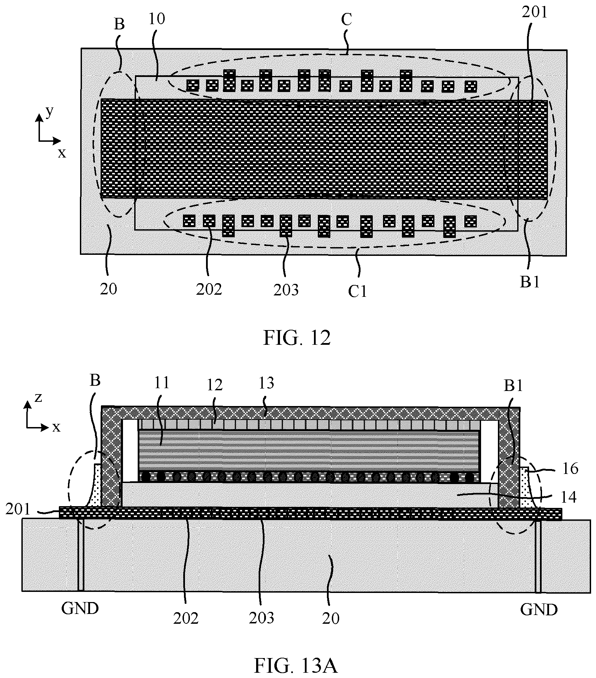

FIG. 12 is a cross-sectional diagram of still another chip system according to an embodiment of this application.

FIG. 12 is a top view of a plane on which an x axis and a y axis are located. To display positions of a solder pad 201 and pins on a PCB 20, a chip package body 10 is represented by using a solid block, and FIG. 12 does not show a first shielding structure and a second shielding structure.

The chip package body 10 includes a chip and a package substrate. The package substrate is located on the solder pad 201, a first end of the second shielding structure is electrically connected to the solder pad 201, and a second end of the second shielding structure is electrically connected to the first shielding structure.

The pins on the PCB 20 include a first pin 202 and a grounding pin 203. Specific distribution and quantities of first pins 202 and grounding pins 203 are not specifically limited in this application. The first pin 202 is a signal transmission pin, and the grounding pin 203 is configured to be grounded.

A projection of the first pin 202 on the plane on which the x axis and the y axis are located is within a range covered by a contour of the chip package body 10. A projection of the grounding pin 203 on the plane on which the x axis and the y axis are located is partially within the range covered by the contour of the chip package body 10, or is completely outside the range covered by the contour of the chip package body 10. In this application, an example in which the grounding pin 203 is partially within the range covered by the contour of the chip package body 10 is used for description.

Projections of two sides of the solder pad 201 on the plane on which the x axis and the y axis are located outside the range covered by the contour of the chip package body 10. Regions extended from the two sides of the solder pad 201, namely, a region B and a region B1 shown in the figure, are used to implement an electrical connection between the solder pad 201 and the first shielding structure by using a soldering process. Specific areas of the region B and the region B1 are not limited in this embodiment of this application.

A region C and a region C1 in the figure are regions in which the chip package body 10 and the PCB 20 are connected by using an electrical signal. In a possible implementation, when an LGA packaging manner is used, a contact required when the chip package body 10 is connected to the PCB 20 is located on the PCB 20, and a lower side of the package substrate covers a grid-shape connection end. The PCB 20 communicates with the chip package body by using a point contact technology. The PCB 20 provides a pin, which may replace the solder ball in BGA packaging.

The region may be filled with an insulation material. The insulation material may be an underfill material, for example, an epoxy resin material. The insulation material may fill a gap according to a capillary principle.

In some other embodiments, the region may not be filled with the insulation material.

FIG. 13A is a cross-sectional diagram 1 corresponding to FIG. 12 according to an embodiment of this application.

FIG. 13A is a cross-sectional diagram of a plane on which an x axis and a z axis are located.

Regions extending from two sides of a solder pad 201, namely, a region B and a region B1 shown in the figure, are used to form a second shielding structure 16 by using a soldering process, so that the solder pad 201 is electrically connected to a first shielding structure 13.

That is, one end of the second shielding structure 16 is connected to the solder pad 201, and the other end is connected to the first shielding structure 13.

A first surface of a chip 11 is fastened to the first shielding structure 13 by using a first material 12.

In a possible implementation, the first material 12 is a TIM material, and the TIM material is mostly a flexible material, for example, may be a gel or a silicone lipide material. When the TIM material is filled between the first surface of the chip 11 and the first shielding structure 13, on one aspect, heat dissipation can be assisted, so that heat generated when the chip 11 works is quickly conducted to the first shielding structure, and on the other aspect, support for the first shielding structure 13 is provided, thereby improving stability of the first shielding structure 13.

In this case, the first shielding structure 13 is a metal mechanical part, and the metal mechanical part may be in a punch form or through casting. This is not specifically limited in this embodiment of this application. The metal mechanical part has a groove structure, and the groove is configured to accommodate a corresponding part of the chip package body, to implement electromagnetic shielding on the chip package body.

Because the solder pad 201 is electrically connected to the first shielding structure 13 by using the second shielding structure 16, when the solder pad 201 is grounded, the second shielding structure 16 and the first shielding structure 13 are also grounded, and this improves electromagnetic shielding performance.

Further, because the grounding pins 203 on the PCB 20 are partially located outside the coverage of the contour of the chip package body 10, the grounding pins 203 may alternatively be electrically connected to the first shielding structure 13 by using a soldering process, to avoid grounding on the PCB 20 through wiring, and this simplifies a ground line.

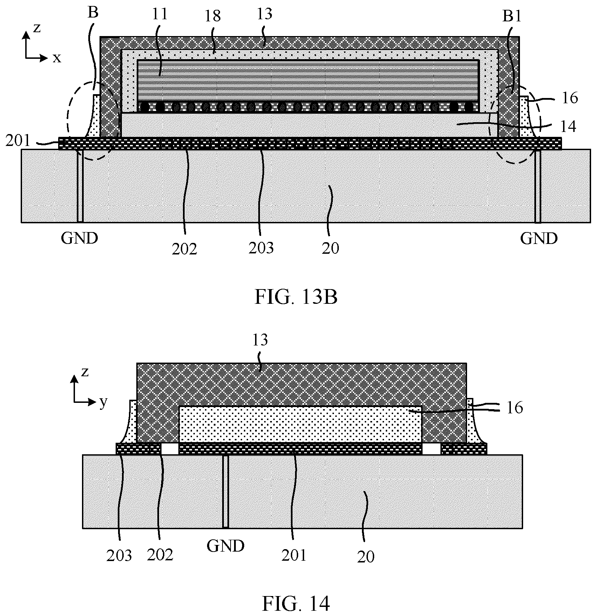

FIG. 13B is a cross-sectional diagram 2 corresponding to FIG. 12 according to an embodiment of this application.

FIG. 13B is a cross-sectional view of a plane on which an x axis and a z axis are located. A difference between this implementation and the implementation shown in FIG. 13A lies in that the chip package body further includes an epoxy molding compound 18, and the chip 11 is buried in the epoxy molding compound 18.

In this case, a first shielding structure 13 may be a conductive film, a metal material, or an electrically conductive adhesive material.

Specifically, when the first shielding structure 13 is implemented by using the conductive film, the conductive film may be formed through spraying.

When the first shielding structure 13 is implemented by using the metal material, the metal material may be formed through metal sputter deposition or deposition by using an electroplating process, and the metal material may alternatively be a metal mechanical part that is in a punch form or through casting.

When the first shielding structure 13 is implemented by using the electrically conductive adhesive material, the electrically conductive adhesive material may be formed through coating.

On one aspect, the epoxy molding compound 18 can assist in heat dissipation, so that heat generated when the chip works is quickly conducted to the first shielding structure 13. On the other aspect, the epoxy molding compound 18 provides support for the first shielding structure 13, and this improves stability of the first shielding structure, and enables the first shielding structure 13 to be formed relying on the epoxy molding compound 18.

The first shielding structure 13 covers an outer surface of the epoxy molding compound 18 and a side wall of the package substrate 14, to encircle the chip package body, and this improves an electromagnetic shielding effect.

FIG. 14 is a side view 1 corresponding to FIG. 12 according to an embodiment of this application.

FIG. 14 is a side view of a plane on which a y axis and a z axis are located. According to FIG. 14, a second shielding structure 16 is formed by using a soldering process, so that a solder pad 201 is electrically connected to a first shielding structure 13, and the second shielding structure 16 covers only a part of the second shielding structure 16 to save materials.

A part of a grounding pin 203 extended to outside a range of the chip package body 10 may alternatively form the second shielding structure 16 by using the soldering process, to implement an electrical connection to the first shielding structure 13. This avoids grounding on a PCB 20 through wiring, and simplifies a grounding line. In addition, the grounding pin 203, the solder pad 201, the first shielding structure 13, and the second shielding structure 16 enclose a first pin 202, and this further improves electromagnetic shielding performance of a chip system.

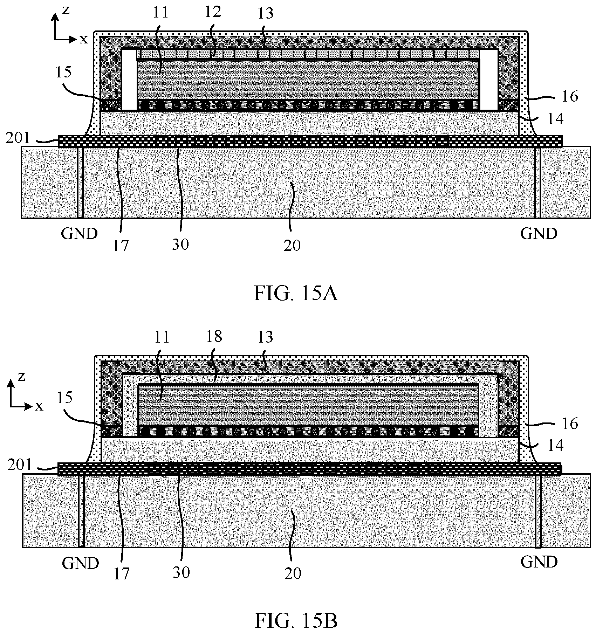

FIG. 15A is a cross-sectional diagram 3 corresponding to FIG. 12 according to an embodiment of this application.

FIG. 15A is a cross-sectional view of a plane on which an x axis and a z axis are located. A difference between the chip system shown in FIG. 15A and that in FIG. 13A lies in that the second shielding structure 16 of the chip system shown in FIG. 15A is a conductive film, and the conductive film covers an exterior of the second shielding structure 13.

FIG. 15B is a cross-sectional diagram 4 corresponding to FIG. 12 according to an embodiment of this application.

FIG. 15B is a cross-sectional view of a plane on which an x axis and a z axis are located. A difference between the chip system shown in FIG. 15B and that in FIG. 15A lies in that: the chip package body further includes an epoxy molding compound 18, and the chip 11 is buried in the epoxy molding compound 18.

In this case, a first shielding structure 13 may be a conductive film, a metal material, or an electrically conductive adhesive material.

Specifically, when the first shielding structure 13 is implemented by using the conductive film, the conductive film may be formed through spraying.

When the first shielding structure 13 is implemented by using the metal material, the metal material may be formed through metal sputter deposition or deposition by using an electroplating process, and the metal material may alternatively be a metal mechanical part that is in a punch form or through casting.

When the first shielding structure 13 is implemented by using the electrically conductive adhesive material, the electrically conductive adhesive material may be formed through coating.

On one aspect, the epoxy molding compound 18 can assist in heat dissipation, so that heat generated when the chip works is quickly conducted to the first shielding structure 13. On the other aspect, the epoxy molding compound 18 provides support for the first shielding structure 13, and this improves stability of the first shielding structure, and enables the first shielding structure 13 to be formed relying on the epoxy molding compound 18.

The first shielding structure 13 covers an outer surface of the epoxy molding compound 18 and a side wall of the package substrate 14, to encircle the chip package body, and this improves an electromagnetic shielding effect.

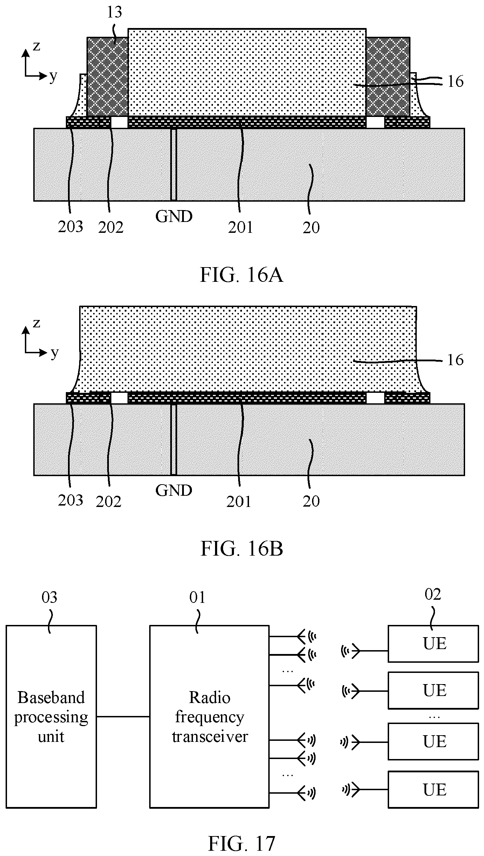

FIG. 16A is a side view 1 corresponding to FIG. 15A and FIG. 15B according to an embodiment of this application.

FIG. 16A is a side view of a plane on which a y axis and a z axis are located. In this case, a second shielding structure includes two parts.

A first part of the second shielding structure is a conductive film, the conductive film covers an exterior of a second shielding structure 13, and the conductive film is fastened by using regions extending from two sides of a solder pad 201.

A part of the grounding pin 203 extends to outside a range of a chip package body 10, and forms a second part of the second shielding structure 16 by using a soldering process, to implement an electrical connection to a first shielding structure 13. This avoids grounding on a PCB 20 through wiring, and simplifies a grounding line. In addition, the grounding pin 203, the solder pad 201, the first shielding structure 13, and the second shielding structure 16 enclose a first pin 202, and this improves electromagnetic shielding performance of a chip system.

FIG. 16B is a side view 2 corresponding to FIG. 15A and FIG. 15B according to an embodiment of this application.

FIG. 16B is a side view of a plane on which a y axis and a z axis are located. A difference between the chip system shown in FIG. 16B and that in FIG. 16A lies in that: the second shielding structure 16 is a conductive film, a part of the grounding pin 203 extending outside a range of the chip package body 10, and a part of two sides of the solder pad 201 extending outside the range of the chip package body 10 are used to electrically connect to the conductive film. The conductive film may completely cover the first shielding structure 13, or completely cover a side wall of the first shielding structure 13.

In this case, the solder pad 201, the first shielding structure 13, and the second shielding structure 16 enclose the first pin 202, and this improves electromagnetic shielding performance of the chip system.

It may be understood that, the foregoing description is provided by using an example in which the first pin 202 and the grounding pin 203 in the chip system are located on an upper side and a lower side of the chip package body 10. In actual application, as a quantity of first pins 202 and grounding pins 203 changes, layout positions of the first pins 202 and the grounding pins 203 may be adjusted accordingly, and may be arranged only on one side, or arranged on three sides, or arranged on four sides. Details are not described herein again.

Based on the chip system provided in the foregoing embodiment, an embodiment of this application further provides a communication device to which the chip system is applied. The following provides specific descriptions.

The communication device includes a PCB, and a chip package body corresponding to an intermediate frequency (Intermediate Frequency, IF) chip and a radio frequency (Radio Frequency, RF) chip on the PCB may use the chip system provided in the foregoing embodiment.

The following uses an example in which the communication device is a radio frequency transceiver for description.

FIG. 17 is a diagram of a radio frequency transceiver system according to an embodiment of this application.

A radio frequency transceiver 01 applied to a wireless communication system supports a multiple-input multiple-output (Multiple-Input Multiple-Output, MIMO) function, and can simultaneously send signals to different user equipment (User Equipment, UE) by using a plurality of transmit antennas, and simultaneously receive, by using a plurality of receive antennas, signals sent by a plurality of UE 02.

A radio frequency transceiver system provided in embodiments of this application includes the radio frequency transceiver 01 and a baseband processing unit (Base band Unit, BBU) 03.

In actual application, the radio frequency transceiver system generally includes a plurality of radio frequency transceivers 01 and a plurality of BBUs 03. One BBU 03 supports simultaneous access of a plurality of radio frequency transceivers 01. A specific quantity of radio frequency transceivers 01 that are simultaneously accessed by one BBU 03 is not limited in embodiments of this application.

When the radio frequency transceiver system includes a plurality of BBUs 03, a quantity of radio frequency transceivers 01 connected to the BBUs 03 may be the same or may be different. This is not specifically limited in embodiments of this application.

The radio frequency transceiver 01 is connected to the BBU 03 through an optical fiber. On one aspect, the radio frequency transceiver 01 obtains, through the optical fiber, an optical signal sent by the BBU, converts the optical signal into a high-speed electrical signal through an optical module, processes the high-speed electrical signal by using an internal baseband circuit, an intermediate frequency circuit, and a radio frequency power amplification circuit, and then sends a high-speed electrical signal to a plurality of user equipment through a plurality of transmit antennas. On the other aspect, the radio frequency transceiver 01 can receive, through a plurality of receive antennas, radio frequency signals sent by the plurality of user equipment, process the radio frequency signals by using the internal radio frequency power amplification circuit, the intermediate frequency circuit, and the baseband circuit, and the radio frequency signals are converted into high-speed electrical signals, and then convert the high-speed electrical signals into optical signals through the optical module, and the optical signals are transmitted to the BBU 03 through the optical fiber.

An intermediate frequency chip of the intermediate frequency circuit may be applied to the chip system provided in this embodiment of this application, that is, the chip package body of the intermediate frequency chip is disposed on a PCB on which the intermediate frequency circuit is located by using the foregoing electromagnetic shield.

In conclusion, the chip system included in the communication device provided in this embodiment of this application can implement electromagnetic shielding on a first connection part, reduce electromagnetic leakage of the first connection part, improve an electromagnetic shielding capability of the chip package body, ensure chip performance, and reduce impact of electromagnetic leakage on another circuit component, thereby improving performance of the communication device.

The foregoing descriptions are merely specific implementations of this application. It should be noted that a person of ordinary skill in the art can further make several improvements and modifications without departing from the principles of this application, and these improvements and modifications shall also be considered as the protection scope of this application.

## Claims

1. A chip system, wherein the chip system comprises a chip package body and an electromagnetic shielding enclosure, the chip package body is electrically connected to a circuit board by using a first connection part, the chip package body comprises a package substrate and at least one chip, the package substrate is electrically connected to the at least one chip, the electromagnetic shielding enclosure comprises a first shielding structure and a second shielding structure, and both the first shielding structure and the second shielding structure are conductive;
the first shielding structure is connected to the package substrate;
the first shielding structure comprises a first cavity, and the first cavity is configured to accommodate the at least one chip;
a first end of the second shielding structure is connected to a solder pad on the circuit board or connected to the circuit board, and a second end of the second shielding structure is connected to the first shielding structure to form a second cavity; or a first end of the second shielding structure is connected to a solder pad on the circuit board or connected to the circuit board, and the second shielding structure covers the first shielding structure to form a second cavity; and
the first connection part is located in the second cavity.

2. The chip system according to claim 1, wherein the first connection part comprises an insulation material and a plurality of electrical connection parts;
the plurality of electrical connection parts are configured to connect the chip package body and the circuit board; and
the insulation material is filled in a region between the package substrate, the circuit board, and the plurality of electrical connection parts.

3. The chip system according to claim 2, wherein the first connection part comprises two connection surfaces, one connection surface close to the circuit board is a first connection surface, the other connection surface close to the chip package body is a second connection surface, and a width of the first connection surface is greater than a width of the second connection surface.

4. The chip system according to claim 2 or 3, wherein the second shielding structure covers all or a part of side walls of the insulation material.

5. The chip system according to any one of claims 1 to 4, wherein the solder pad is grounded.

6. The chip system according to claim 5, wherein the package substrate is located on the solder pad, and the first end of the second shielding structure is electrically connected to the solder pad.

7. The chip system according to claim 6, wherein the chip package body is electrically connected to the circuit board by using a land grid array LGA packaging technology, and a grounding pin of the chip package body is electrically connected to the second shielding structure.

8. The chip system according to any one of claims 1 to 7, wherein a first surface of each of the at least one chip is connected to the first shielding structure by using a first material;
a second surface of each of the at least one chip is electrically connected to a first surface of the package substrate; and
the first shielding structure is connected to the first surface of the package substrate by using a second connection part.

9. The chip system according to claim 8, wherein the second connection part is a metal solder; or the second connection part is an electrically conductive adhesive; or the second connection part is an insulation collosol.

10. The chip system according to any one of claims 1 to 7, wherein a first surface of each of the at least one chip is connected to the first shielding structure by using a first material;
a second surface of each of the at least one chip is electrically connected to a first surface of the package substrate; and
the first shielding structure is connected to a side wall of the package substrate by using a second connection part.

11. The chip system according to claim 9, wherein the second connection part is a metal solder; or the second connection part is an electrically conductive adhesive; or the second connection part is an insulation collosol.

12. The chip system according to any one of claims 1 to 11, wherein the first shielding structure is a metal mechanical part.

13. The chip system according to any one of claims 1 to 7, wherein the chip package body further comprises an epoxy molding compound;
each of the at least one chip is buried in the epoxy molding compound; and
the first shielding structure covers an outer surface of the epoxy molding compound and a side wall of the package substrate.

14. The chip system according to any one of claims 1 to 7, wherein the chip package body further comprises an epoxy molding compound;
the at least one chip is buried in the epoxy molding compound;
each of the at least one chip is electrically connected to a first surface of the package substrate; and
the first shielding structure covers an outer surface of the epoxy molding compound, and extends to the first surface of the package substrate.

15. The chip system according to claim 13 or 14, wherein the first shielding structure is any one of the following:
a conductive film, a metal material, or an electrically conductive adhesive material.

16. The chip system according to any one of claims 1 to 15, wherein the second shielding structure is any one of the following:
a conductive film, a metal material, or an electrically conductive adhesive material.

17. The chip system according to claim 2, wherein the plurality of electrical connection parts are any one of the following:
a metal solder ball, a sinter, a metal mechanical part, or a plug terminal.

18. The chip system according to any one of claims 1 to 17, wherein the second shielding structure completely covers the first shielding structure, and a cohesive material is provided on a contact surface of the second shielding structure and the first shielding structure.

19. The chip system according to any one of claims 1 to 18, wherein the second shielding structure is located on an outer side of the first shielding structure, and at least a part of the second cavity is located between the package substrate and the circuit board.

20. A communication device, wherein the communication device comprises the chip system according to any one of claims 1 to 19.

21. The communication device according to claim 20, wherein the communication device is a radio frequency transceiver; and
the radio frequency transceiver is configured to be connected to a baseband processing unit BBU of a base station through an optical fiber.

22. The communication device according to claim 20 or 21, wherein the at least one chip comprises an intermediate frequency IF chip.
